# EUROPÄISCHE PATENTSCHRIFT

(11) **EP 3 195 334 B1**
(45) Veröffentlichungstag und Bekanntmachung des Hinweises auf die Patenterteilung: **25.07.2018**
(21) Anmeldenummer: 14780755.6
(22) Anmeldetag: 17.09.2014
(51) Int. Cl.: H01F 27/02, F41H 5/02

(54) **BESCHUSSBESTÄNDIGE ELEKTRISCHE ANLAGE**
BULLET-RESISTANT ELECTRICAL INSTALLATION
INSTALLATION ÉLECTRIQUE RÉSISTANT AUX TIRS

(43) Veröffentlichungstag der Anmeldung: 26.07.2017
(60) Teilanmeldung: 17001864.2
(73) Patentinhaber: Siemens Aktiengesellschaft, 80333 München (DE)
(72) Erfinder: LEBER, Gerald, 8211 Grosspesendorf (AT)
(74) Vertreter: Maier, Daniel Oliver
(86) Internationale Anmeldenummer: PCT/EP2014/002516
(87) Internationale Veröffentlichungsnummer: WO 2016/041566

(56) Entgegenhaltungen:
- DE-A1- 3 633 349
- DE-A1- 3 729 048
- DE-A1- 10 002 630
- DE-U1- 8 609 852

## Beschreibung

### Technisches Gebiet

Die Erfindung betrifft allgemein das technische Gebiet elektrischer Anlagen, insbesondere elektrische Transformatoren, Phasenschieber und Drosseln großer Nennleistung, wie Sie üblicherweise in Energieverteilungsnetzen eingesetzt werden.

### Stand der Technik

Elektrische Anlagen, wie Transformatoren, Drosseln oder Schaltvorrichtungen, stellen in einem Energieverteilungsnetz Knotenpunkte dar, die in Krisenzeiten potentielle Angriffsziele für zerstörerische Anschläge von außen sein können. Solche Anschläge sind beispielsweise. Angriffe aus umgebendem Terrain durch Beschuss mit Handfeuerwaffen, durch Sprengsatz, der in der Nähe der elektrischen Anlage detoniert, oder auch durch Granat- und Bombensplitter. Besonders verwundbar sind dabei die Seitenwände eines mit einem Fluid gefüllten Kessel. Wenn ein Beschuss auf diese Seitenwände auftrifft, kann - je nach Intensität der Geschosseinwirkung - ein Leck auftreten. Aber auch dann, wenn der Kessel dicht bleibt, kann sich in einem flüssigkeitsgefüllten Kessel eine Druckwelle fortpflanzen, die Sicherheitseinrichtungen dazu veranlasst, die Anlage abzuschalten. In beiden Fällen kann die Energieversorgung durch den Angriff beeinträchtigt sein.

Aus der DE 37 29 048 A1 ist beispielsweise ein Objektschutz für einen Transformator mit großer Nennleistung bekannt, bei dem zum Schutz vor äußeren mechanischen Einwirkungen die Seitenwände des Transformatorkessels innenseitig mit Schutzplatten armiert sind. Die Schutzplatten sind innenseitig an die Seitenwände geschweißt und bestehen aus einem Sonderstahl zum Abfangen von Splitter und Geschossen. Ein Nachteil ist, dass im Bereich der Schweißnaht die schützende Armierung geschwächt ist. Ein weiterer Nachteil ist, dass im Falle eines Beschlusses sich im flüssigkeitsgefüllten Kessel Druckwellen fortpflanzen, was dazu führen kann, dass Sicherheitseinrichtungen den Transformator abschalten. Dann ist die Energieversorgung zumindest zeitweise unterbrochen. Aus DE100 02 630 ist eine Umspannstation mit wenigstens einen Raum für einen Transformator bekannt.

### Darstellung der Erfindung

Es ist eine Aufgabe der vorliegenden Erfindung eine elektrische Anlage in einem Energieverteilungsnetz, insbesondere einen Transformator oder eine Drossel so zu schützen, dass auch im Falle eines Angriffs mit Handfeuerwaffen oder mit einem Sprengsatz die Energieversorgung nicht beeinträchtigt wird.

Gelöst wird diese Aufgabe durch eine elektrische Anlage mit den Merkmalen des Anspruchs 1. Die Aufgabe wird auch durch ein Verfahren zum Nachrüsten einer bestehenden elektrischen Anlage gemäß Anspruch 13 gelöst. Vorteilhafte Ausgestaltungen der Erfindung sind in den jeweils abhängigen Ansprüchen definiert.

Die vorrichtungsbezogene Aufgabe wird gelöst durch eine elektrische Anlage gemäß Anspruch 1.

Die Beschussbeständigkeit kann also erreicht werden, indem der Kessel selbst aus herkömmlich verwendetem Stahl gefertigt ist und außenseitig mit einer Armierung umhüllt ist, die eine Zugefestigkeit Rₘ von größer als 1000 MPa aufweist. Die Zugfestigkeit von Materialien ist in DIN EN ISO 6892-1 definiert.
Einem Grundgedanken der Erfindung nach wird also der Objektschutz durch eine durchschusshemmende Ausführung des Kessels bzw. der Armierung oder Panzerung erreicht. Das Fluid im Kessel kann eine Kühl- oder Isolationsflüssigkeit sein, z.B. Trafo-Öl, oder ein Gas in einer Schalteranlage.
Unter dem Begriff beschussbeständig ist die Beständigkeit eines Materials oder einer Konstruktion zu verstehen, einer Durchdringung eines Geschosses unter definierten Bedingungen stand zu halten. Eine Definition der Geschossbeständigkeit ist beispielsweise in der amerikanischen Norm UL 742 (Ratings of Bullet Resistant materials) durch Level 1 bis Level 10 definiert. Korrespondierend hierzu sind in der allgemeinen Prüfungsrichtlinie 2006 der Vereinigung der Prüfstellen für angriffhemmende Materialien und Konstruktionen (VPMA APR 2006) Prüfstufen zwischen 1 und 14 definiert. Die Prüfstufe 1 beginnt mit einem Kaliber .22 Ir, einer Geschossmasse von 2,6 g und einer Geschossenergie von etwa 160 J (Joule). Die Prüfstufe 14 umfasst ein Kaliber 14,5 x 114, eine Geschossmasse von etwa 64 g und eine Geschossenergie von 26308 J (Joule). In der europäischen Norm DIN EN 1063 sind korrespondierende Bereiche zwischen BR1 und BR 7 definiert. Diese ballistisch definierte beschusshemmende Wirkung gegenüber einer Faustfeuerwaffe bzw. Langwaffe gilt im Sinne der Erfindung analog auch für die Splitterwirkung eines in der Nähe der Anlage detonierenden Sprengkörpers. Mit anderen Worten, die erfindungsgemäße Schutzmaßnahme umfasst zumindest einen in den oben angegebenen Normen angegebenen Wirkungsbereich. Mit anderen Worten, eine Beschusseinwirkung in einem solchen Bereich führt nicht dazu, dass im Kessel der elektrischen Anlage ein Leck auftritt. Eine Schutzmaßnahme innerhalb dieses Wirkungsbereichs (Level 1 bis 10, bzw. Prüfstufe 1-14) lässt sich mit vertretbarem Aufwand realisieren. Prinzipiell kann eine elektrische Anlage auch über diesen Wirkungsbereich hinausgehend gegen Beschuss geschützt werden.
Erfindungsgemäß wird für die Schutzmaßnahme ein Werkstoff verwendet, der eine Zugfestigkeit Rm aufweist, die größer als 1000 MPa (Mega Pascal)ist. Eine hohe Zugfestigkeit macht den Werkstoff für eine Armierung oder Panzerung besonders geeignet. Ein solcher Werkstoff mit hoher Zugfestigkeit kann ein metallischer oder auch ein nicht metallischer Werkstoff sein, zum Beispiel ein Polymerwerkstoff, ein mit Carbonfaser verstärkter Kunststoff, ein Werkstoff auf der Basis von Polyethylen, oder Aramidfasern. Bekannte Markennamen für Aramidfasern sind beispielsweise Nomex® und Kevlar® von DuPont. Dabei können die Kunststofffasern unterschiedlich miteinander verwoben und verwirkt sein. Auch eine Sandwich-Konstruktion aus einem Verbund bestehend aus Metall und Nichtmetall (einem Kunststoff, einem Kohlenstofffasern-Vlies oder ähnlichen) ist als Werkstoff für die durchschusshemmende Armierung prinzipiell geeignet. Der Vorteil eines Polymers liegt im vergleichsweise geringeren Gewicht, demgegenüber stehen höhere Kosten.

Bevorzugt ist eine Ausführung, bei der die Armierung die Seitenwände des Kessels ringsum in einem Abstand umhüllt und mittels mehrerer Befestigungselemente am Kessel befestigt ist. Indem die durchschusshemmende Armierung mit mehreren Stützstellen unter Einhaltung eines Abstandes an der Anlage befestigt ist, kommt es nicht zu einer punktuellen Einwirkung auf die Wandung des Kessels, sondern es wird eine energieverzehrende Wirkung erreicht: die Geschossenergie, die außen auf die Armierung auftrifft, wird nicht unmittelbar an der Trefferstelle an die Flüssigkeit im Kesselinneren weitergeleitet, sondern - aufgeteilt auf mehrere Stützstellen - jeweils nur ein Anteil dieser Energie. Dadurch ist die sich in der Kühl- und Isolationsflüssigkeit ausbreitende Druckwelle in ihrer Intensität geringer. Trifft diese auf eine Schutzeinrichtung (zum Beispiel ein Buchholzschutz oder ein Druckentlastungsventil), so ist das Risiko, dass diese Druckwelle unerwünscht zum Abschalten der Anlage führt, verringert. Da die Armierung nicht innenseitig, sondern außenseitig am Kessel befestigt wird, ergeben sich eine Reihe von Vorteilen: Der Schutz kann nachträglich montiert werden. Zunächst vergrößert die Panzerung nicht die Außenabmessungen der Anlage. Die Panzerplatten können getrennt gefertigt und transportiert werden. Insbesondere für große Leistungstransformatoren ist es von besonderem Vorteil, wenn die Panzerung erst am Betriebsort montiert wird, dann ist der Transport durch urbane Gebiete und durch Tunnel - der bereits heutzutage wegen der Abmessungen an seine Grenzen stößt - leichter.

Ein weiterer Vorteil ist, dass auch ein bereits in Betrieb befindlicher Transformator bzw. eine Drossel mit vergleichsweise geringem technischem Aufwand nachgerüstet werden kann. Die Anbringung der Panzerung an der Außenseite kann einfach an bereits vorhandenen Verstärkungen und Kessel-Rippen erfolgen.

Hinsichtlich der Herstellungskosten kann eine Ausführung vorteilhaft sein, bei der die beschussfeste Armierung aus einem Blech hergestellt ist, das aus einem kohlenstoffreichen, gehärteten Stahl besteht, wobei das Blech eine Zugfestigkeit Rm >1000 Mega Pascal aufweist. Günstige ist dabei wenn das Blech eine Brinell-Härte von 300-500 aufweist. Mit einem entsprechenden Schutzanstrich versehen, ist die aus Blechen hergestellte Schutzhülle witterungsbeständig. Ergebnisse von Beschussversuchen haben gezeigt, dass bei einem Leistungstransformator mit vertretbarem Aufwand eine VPAM Prüfstufe 12 und auch darüber hinaus ohne weiteres realisiert werden kann.

In einer besonders bevorzugten Ausführungsform kann die durchschusshemmende Armierung aus einzelnen Platten bzw. Paneelen gebildet sein, wobei benachbarte Paneele einander überlappen. Indem die Panzerung durch einzelne Teile zusammengesetzt wird, verringern sich die Abmessungen und lassen sich leichter handhaben und transportieren. Auch die Bevorratung ist einfacher. Kommt es tatsächlich zu einem Beschuss oder einer Splittereinwirkung können beschädigte Paneele einfach ausgewechselt werden. Die einzelnen Platten können mehrschichtig aufgebaut sein und metallische und nichtmetallische Schichte aufweisen.

Mit Vorteil können die Paneele so montiert sein, dass sie in ihrer Längserstreckung vertikal und parallel zueinander liegen. Dadurch sind weniger Befestigungselemente zwischen und Paneel und Anlage bzw. Transformator erforderlich.

In einer besonders bevorzugten Ausführungsform kann vorgesehen sein, dass jedes der Paneele ein Profil, z.B. in Form eines U-, S-, Z-, V- oder C-Profils ausgebildet ist, wobei benachbarte Schenkel untergreifen. Ein Profil erhöht das Widerstands- und Trägheitsmoment. Verglichen mit einer Schweißnaht gibt es keine Material-Schwächung und auch kein Verziehen. Bei Beschuss mit automatischen Waffen verbessert sich die "Multi-Hit-Eigenschaft". Das U-, S-, Z-, V- oder C-Profil kann dabei im Querschnitt so ausgebildet sein, dass die Schenkelteile eines solchen Profils mit dem verbindenden Mittelteil einen stumpfen Winkel einschließen. Die Anordnung der Paneele ist im Montagezustand dabei so gewählt, dass sich benachbarte Paneele mit ihren Schenkeln untergreifen. Durch diesen Untergriff wird erreicht, dass zwischen Paneelen keine Geschoss- oder Splitterkörper eindringen und die Kesselwand beschädigen können. Um die Emission von Betriebsgeräuschen gering zu halten, kann dabei von Vorteil sein, wenn benachbarte Paneele nicht direkt aneinander anliegen, sondern dazwischen ein Spalt gelassen ist.

In einer bevorzugten Ausführungsform kann vorgesehen sein, dass zur Befestigung der Paneele jeweils ein kesselseitiges bzw. paneelseitiges Konsolen-Teil verwendet wird, wobei diese Konsolenteile jeweils mittels eines Federelementes verbunden sind. Das Federelement besitzt eine elastisch nachgebende Wirkung, wodurch die kinetische Energie eines auftreffenden Geschosses oder eines Splitters nicht direkt in das Innere des mit Flüssigkeit gefüllten Kessel geleitet wird. Damit ist die sich in der Kühl- bzw. Isolationsflüssigkeit fortpflanzende Stoßwelle in ihrer Amplitude geringer. Ein ungewolltes Auslösen einer Sicherheitseinrichtung wird unterbunden.

Eine kostengünstige Ausbildung einer Befestigungsvorrichtung kann so konstruiert sein, dass zwischen den beiden Konsolen-Teilen ein Federelement, z.B. entweder eine metallische Feder oder ein elastomerer Werkstoff angeordnet ist. Ein Gummi kann durch Adhäsion an entsprechenden Metallteilen beidseits durch Vulkanisation befestigt sein. Solche schwingungsdämpfenden Metall-Gummi-Metall-Bauteile sind kommerziell erhältlich.

Je nach Ausführung des Transformators oder der Drossel können zum Zwecke des elektrischen Anschlusses auf dem Kesseldeckel Dome mit Hochspannungs-Durchführung und/oder andere Anlagenteile angeordnet sein. Um auch diese Anlagenteile, - sofern sie im Projektions- bzw. Sichtbereich des umgebenden Terrains der Anlage liegen -, zu schützen, kann vorgesehen sein, dass die vertikal angeordneten Paneele mit ihrem oberen Ende über diese Dome und/oder Anlagenteile hinausragen. Dadurch sind auch diese hoch liegenden Anlagenteile vor Beschuss und Splittereinwirkung aus dem umgebenden Terrain geschützt.

Es gibt auch Ausführungsformen von Transformatoren, bei denen der Deckel des Kessels ein vergleichsweise großes Dehngefäß trägt, das über die Grundfläche des Kessels seitlich hinausragt. Um auch dieses Dehngefäß vor Beschuss und Splittereinwirkung zu schützen, ist in einer besonderen Ausführung der Erfindung vorgesehen, dass die Oberfläche dieses Dehngefäßes ebenfalls mit einer durchschusshemmenden Armierung bzw. Panzerung zumindest insoweit umgeben ist, dass bei einem Angriff aus dem umgebenden Terrain keine Beschädigung erfolgt.

Die Aufgabe der Erfindung wird auch durch ein Verfahren zum Nachrüsten einer elektrischen Anlage, zum Beispiel eines Transformators, eines Phasenschiebers oder einer Drossel gelöst. Dabei werden die Seitenwände einer bereits in Betrieb stehenden Anlage mit einer durchschusshemmenden Armierung versehen. Die beschusshemmende Armierung wird nachträglich außenseitig am Trafo bzw. Drossel mittels Befestigungselemente befestigt, wobei ringsum zwischen Seitenwänden und Armierung ein Abstand gehalten ist. Der dadurch gebildete Zwischenraum kann zum Zwecke der Dämmung von Betriebsgeräuschen mit einem Dämmmaterial gefüllt bzw. ausgekleidet werden.

### Kurzbeschreibung der Zeichnung

Zur weiteren Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind.

Es zeigen:
- Figur 1: eine perspektivische Ansicht eines Transformators, dessen Kessel-Seitenwände von einer durchschusshemmenden Armierung umhüllt ist;
- Figur 2: der Transformator gemäß Figur 1, in einem Blickwinkel von schräg unten auf den vorderseitig angebrachten Radiator;
- Figur 3: den Transformator gemäß Figur 1, in einer Draufsicht;
- Figur 4: eine Ausführung der Erfindung, bei der die Armierung durch einzelne vertikal angeordnete Paneele gebildet ist, gemäß Detail X der Figur 3;
- Figur 5: eine beispielhafte Ausführung einer Befestigung der Paneele am Kessel.

### Ausführung der Erfindung

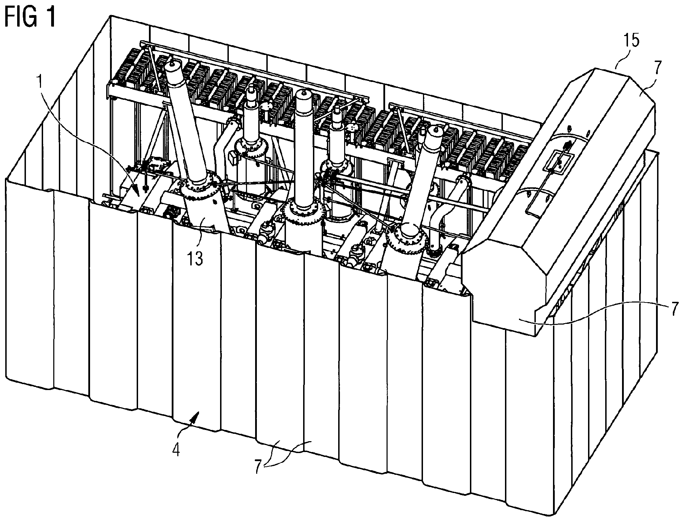

Die Figur 1 zeigt in einer perspektivischen Ansicht eine beschussbeständige elektrische Anlage, dargestellt am Beispiel eines Leistungstransformators 1. Der Leistungstransformator 1 steht dabei auf einem nicht näher dargestellten Fundament. Gemäß dem dargestellten Ausführungsbeispiel umhüllt die durchschusshemmende Armierung bzw. Panzerung 4 die Seitenwände des Leistungstransformators 1 und ragt bis in den Bodenbereich. Die Panzerung 4 ist hinsichtlich ihrer Beschaffenheit und ihrer Abmessung so konstruiert, dass sie einer vom umgebenden Terrain ausgehenden Beschuss- oder Splitter-Bedrohung standhält, so dass alle Anlagenteile geschützt sind.
Im dargestellten Ausführungsbeispiel der Figur 1 besteht diese Armierung bzw. Panzerung 4 aus einzelnen Platten oder Paneelen 7, die eine vertikale Schutzwand bilden. Diese aneinandergereihten Platten 7 umschließen die Anlage 1 ringsum. Sie bilden eine vor Beschuss und Splittereinwirkung schützende Schutzhülle. Gefertigt sind die einzelnen Paneele 7 aus einem Stahlblech, dessen Zugfestigkeit Rₘ > 1000 Mega Pascal ist. Die Blechdicke richtet sich je nach angestrebtem Rating (UL 752) bzw. je nach Prüfstufe (VPAM APR 2006). Die Länge der einzelnen Paneele 7 ist dabei so bemessen, dass eine aus dem umgebenden Terrain einwirkende Beschuss- oder Splittereinwirkung weder den Transformator 1, noch den auf dem Kesseldeckel befindlichen Anlagenteilen Schaden zufügen kann. Wie in Figur 1 dargestellt, überragen daher die einzelnen Paneele 7 mit ihrem oberen Ende die auf dem Kesseldeckel angeordneten Anlagenkomponenten, wie Unterteile von Hochspannungs-Durchführungen und Dome 10 oder andere Anlagenteile des Leistungstransformators 1.

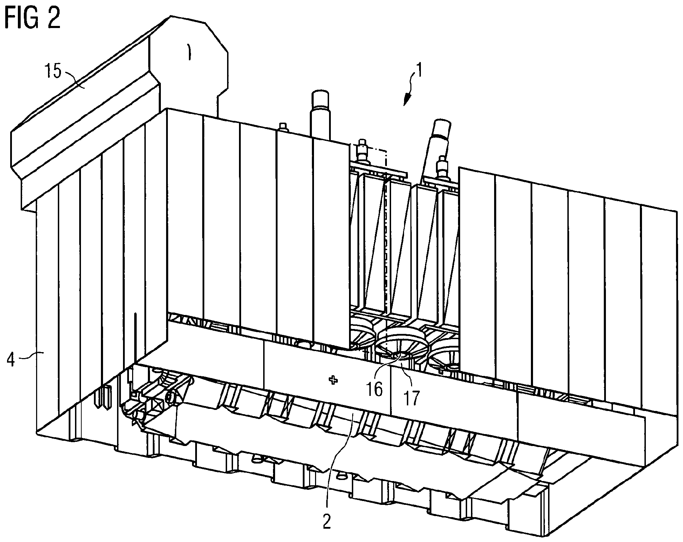

Figur 2 zeigt den in Figur 1 dargestellten Leistungstransformator 1 ebenfalls in einer perspektivischen Ansicht, diesmal aber mit Blickrichtung von hinten und schräg unten. Der Leistungstransformator 1 besitzt zur Abfuhr der Betriebswärme an einer Längs-Seitenwand einen Radiator 16. Der Blick ist in Figur 2 von schräg unten auf diesen Radiator 16 gerichtet. Der Radiator 16 ist außenseitig ebenfalls gepanzert und vor zerstörerischer Seiteneinwirkung geschützt. Zum Zweck der Kühlung ist zwar ein vertikaler Kühlkanal im Bereich des Radiator 16 offen gelassen, dieser ist aber ebenfalls außenseitig durch Paneele 7 kugel- bzw. splittersicher abgeschirmt.

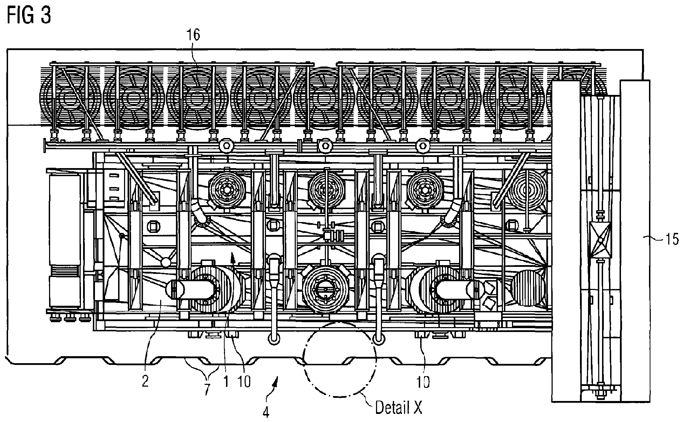

Figur 3 zeigt den Leistungstransformator 1 gemäß Figur 1 in einer Draufsicht. Der Radiator 16 befindet sich auf einer langen Seitenwand des Trafo 1. Die Verbindung mit dem Energieversorgungsnetz erfolgt über Hochspannungs-Durchführungen und Dome 10 die auf dem Dach des Kessels 2 angeordnet sind. Auf dem Deckel des Kessels 2 befindet sich auch ein Dehngefäß 15. Das Dehngefäß 15 hat die Form eines Zylinders. Die Mantelfläche des Dehngefäßes 15 liegt etwa parallel zur Ebene des Kesseldeckels. Eine Stirnseite des Zylinders springt seitlich vom Grundriss des Transformatorkessels vor. Wie in der Zeichnung der Figur 3 dargestellt ist nicht nur der Kessel 2, sondern auch die Oberfläche des Dehngefäß 17, d.h. dessen Mantelfläche und Stirnseiten, von einer Panzerung 4 abgedeckt. Diese Panzerung 4 kann ebenfalls aus einzelnen Paneelen 7 zusammengesetzt sein. Die Paneele 7 sind hier vertikal und horizontal angeordnet.

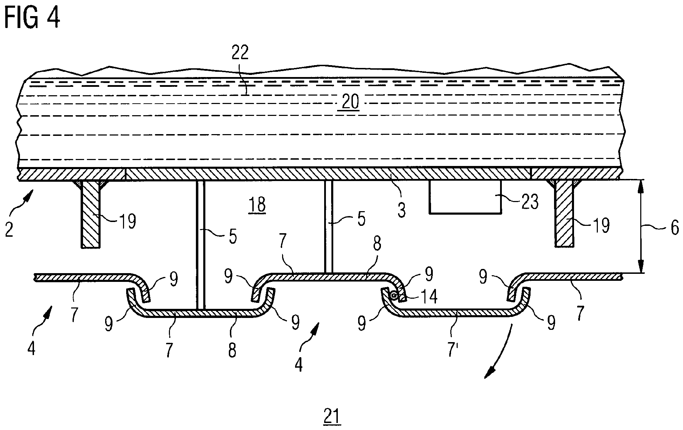

Figur 4 zeigt ein Detail X der Figur 3 in einer vergrößerten Darstellung. Gezeichnet ist beispielhaft eine bevorzugte Profilierung und Anordnung der einzelnen Paneele 7. Die Paneele 7 sind nebeneinanderliegend vertikal angeordnet. Die Paneele 7 überlappen einander seitlich. Jedes Paneel 7 ist mittels mehrerer Befestigungselemente 5 mit dem Kessel 2 bzw. einer Seitenwand 3 des Kessels 2 verbunden. Die Befestigung kann entweder direkt an der Kesselwand 3 verankert sein, oder an Rippen oder Verstärkungen 19 des Kessels 2. Die einzelnen Paneele 7 der Armierung 4 sind in einem Abstand 6 rings umlaufend zur Kesselwand 3 angeordnet. Die Befestigungselemente 5, die im Folgenden noch näher beschriebenen werden, befinden sich in einem umlaufenden Zwischenraum 18, der durch die Kesselwand 3 und die gegenüberleigende Innenseite der Paneele 9 begrenzt wird. Wie in Figur 4 dargestellt, haben die Paneele 7 in einer bevorzugten Ausführung die Form eines U-Profils, bestehend aus zwei Schenkelteilen 9 und einem Verbindungsteil 8. Die Schenkelteile 9 sind bezüglich dem sie verbindenden Verbindungsteil 8 hochgebogen und schließen mit diesem Verbindungsteil 8 jeweils einen stumpfen Winkel ein. Die Anordnung ist dabei so gewählt, dass benachbart zueinander liegende Paneele 7 bezüglich ihres Querschnitts spiegelbildlich zueinander liegen. In dieser Anordnung untergreifen Schenkelteile 9 einander. Dabei ist ein Spalt gelassen. Der Spalt und die Form der Biegung der Schenkel 9 sind so bemessen, dass quasi ein Labyrinth gebildet wird. Dieses Labyrinth wehrt im Bereich der Stoßstelle ein Eindringen eines aus dem Außenraum 21 abgeschossenen Beschuss- oder Splitterkörpers ab. Trifft ein Splitter oder eine Kugel auf eines der Paneele 7, so ist durch die Anbringung der Befestigungselemente 5 sichergestellt, dass sich die Energie des Geschosses auf mehrere Befestigungspunkte aufteilt. Jedes Paneel 7 ist durch mehrere Stützstellen am Kessel 2 abgestützt. Damit ist die Druckwelle, die sich in der Kühl- und Isolationsflüssigkeit 22 im Kesselinnenraum 20 ausbreitet in ihrer Intensität geringer. Dadurch kann vermieden werden, dass es im Falle der Einwirkung eines Beschlusses oder einer äußeren Explosionseinwirkung zu einem unbeabsichtigten Abschalten der Anlage kommt. Die Versorgung mit elektrischer Energie in einem Verteilungsnetz wird im Falle eines zerstörerischen Angriffes aufrechterhalten. Sofern es zu einer starken Beschädigung von Paneelen kommt können diese auf einfache Weise gewechselt werden.

In der Darstellung der Figur 4 ist auch ein Scharnier 14 zu sehen, wodurch das Paneele 7' gemäß dem Pfeil vom Transformator-Kessel 2 weg geschwenkt werden kann. Durch diese Schwenkmöglichkeit eines oder mehrere der Paneele 7' ist es möglich, dass Betriebsmittel oder Anbauteile 23, die sich im Zwischenraum 18 zwischen Armierung 4 und Kesselwand 3 befinden, von außen zugänglich sind. Ein solches Betriebsmittel 23 kann eine Anzeige-, Schalt-, oder Verbindungseinrichtung sein.

Ein Paneel 7 kann eine Breite von 20 cm bis in den Bereich von Metern aufweisen. Das Scharnier 17 kann sich über die gesamte Höhe oder nur über einen Höhenabschnitt erstrecken.

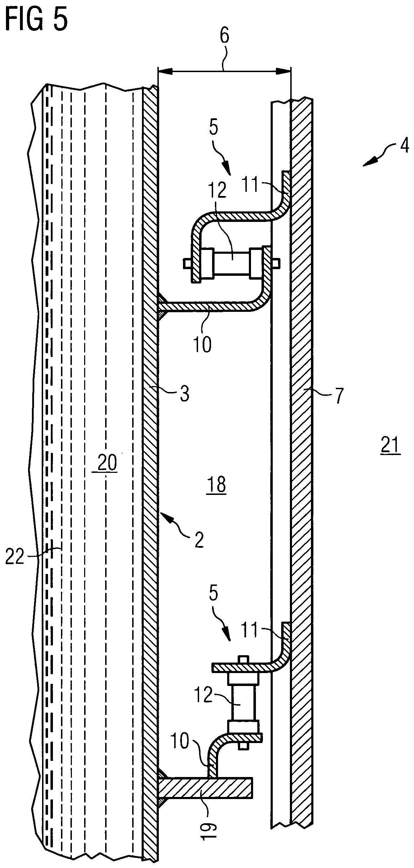

Die Figur 5 zeigt eine mögliche Ausbildung der Befestigungsvorrichtung 5 der Paneele 7 am Kessel 2. Die Paneele 7 sind in einem Abstand 6 bezüglich der Kesselwand 3 vertikal befestigt. Zwischen der Kesselwand 2 und einem Paneel 7 ist ein Zwischenraum 18. In Figur 5 ist beispielhaft eine Befestigung mit zwei Befestigungselementen 5 dargestellt. Das obere und das untere Befestigungselement 5 besteht dabei im Wesentlichen aus einem Metall-Gummi-Metall-Bauteil, der mittels einer kesselseitigen Konsole 10 und einer paneelseitigen Konsole 11 jeweils an der Kesselwand 2 bzw. am Paneel 7 befestigt ist. In der dargestellten beispielhaften Ausführung ist der obere Befestigungskörper 5 horizontal, der untere Befestigungskörper 5 vertikal angeordnet. Dies erleichtert die Montage, indem das Paneel 7 unten eingehängt und anschließend oben beispielsweise durch eine Schraubverbindung befestigt wird. Das Paneel 7 ist dadurch schwingungstechnische vom Kessel 2 entkoppelt. Anstelle von Gummi kann auch ein Federstahl zur Entkoppelung und Befestigung verwendet werden.

Um Betriebsgeräusche zu minder, bietet es sich an, den in Figur 4 und 5 gezeichnete ringförmige Zwischenraum 18 mit einem geräuschdämmenden Material zu füllen.

Obwohl die Erfindung im Detail durch bevorzugte Ausführungsbeispiele näher illustriert und beschrieben wurde, so ist die Erfindung nicht durch die offenbarten Beispiele eingeschränkt. Andere Variationen können vom Fachmann hieraus abgeleitet werden, ohne den Schutzumfang der Erfindung zu verlassen.

So kann es je nach Größe eines Leistungstransformators oder einer Drossel vorteilhaft sein, jedes Paneel 7 mit mehreren Befestigungspunkten am Kessel 2 zu befestigen. Selbstverständlich können zur Befestigung die am Kessel 2 bereits vorhandenen Verstärkungen bzw. Rippen benutzt bzw. mitbenutzt werden. Geeignete Befestigungsmöglichkeiten können bevorzugt bei der Herstellung des Kessels bereits durch Schweißverbindung vorgesehen sein. Im dargestellten Ausführungsbeispiel besteht ein Paneel 7 aus einem einzigen Stahlblech mit einer hohen Zugfestigkeit. Um Beschuss- oder Explosiveinwirkung vom Kessel fernzuhalten können aber auch nichtmetallische Werkstoffe eingesetzt werden. Es ist denkbar, dass die Paneele 7 Sandwichpaneele sind, oder aus einem Kunststoff-Metallverbundwerkstoff hergestellt sind. Es ist auch denkbar, dass für die Panzerung 7 ausschließlich ein Polymerwerkstoff verwendet wird, zum Beispiel aus einzelnen aus Kunststoff-Paneelen 7 besteht. Die Panzerung 4 wird dadurch leichtgewichtig, aber auch teurer. Beispielsweise die Kunststoff-Paneele 7 aus der Aramidfaser Kevlar®, oder einem High Performance Polyethylen (HPDE) oder einem anderen geeigneten Polymer hergestellt sind.

Die Erfindung ist nicht auf den oben beschriebenen Leistungstransformator beschränkt, sondern allgemein auf elektrische Anlagen in Energieversorgungsnetzen anwendbar, zum Beispiel mit Schutzgas betriebene Hochspannungsschalter oder ähnlichen Anlagen.

### Zusammenstellung der verwendeten Bezugszeichen

- 1: Transformator
- 2: Kessel
- 3: Seitenwand
- 4: Armierung, Panzerung
- 5: Befestigungselement
- 6: Abstand
- 7, 7': Paneel
- 8: Verbindungsteil U-Profil
- 9: Schenkel
- 10: Konsole zum Kessel
- 11: Konsole zum Paneel
- 12: Federelement
- 13: Dom
- 14: Scharnier
- 15: Dehngefäß
- 16: Kühlradiator
- 17: Kühleröffnung
- 18: Zwischenraum
- 19: Versteifung an Kesselwand außen
- 20: Innenraum des Kessels
- 21: Außenraum
- 22: Kühl- und Isolationsflüssigkeit
- 23: Betriebsmittel, Anbauteile

## Patentansprüche

1. Elektrische Anlage, insbesondere Transformator, Phasenschieber oder Drossel, mit einem fluidgefüllten Kessel (2), der Seitenwände (3) aufweist, wobei zum Schutz vor Beschuss- und/oder Splittereinwirkung eine durchschusshemmende Armierung (4) vorgesehen ist, die außenseitig die Seitenwände (3) umhüllt, und aus einem Werkstoff besteht, der eine Zugefestigkeit Rₘ aufweist, die größer als 1000 MPa ist, **dadurch gekennzeichnet, dass** die Armierung (4) die Seitenwände (3) ringsum in einem Abstand (6) umhüllt und mittels mehrerer Befestigungselemente (5) am Kessel (2) befestigt ist.

2. Elektrische Anlage nach Anspruch 1, **dadurch gekennzeichnet, dass** die Armierung (4) aus Paneelen (7) gebildet ist, wobei benachbarte Paneele (7, 7') einander überlappen.

3. Elektrische Anlage nach Anspruch 2, **dadurch gekennzeichnet, dass** die Paneele (7) in ihrer Längserstreckung vertikal und/oder horizontal angeordnet sind.

4. Elektrische Anlage nach Anspruch 2 oder 3, **dadurch gekennzeichnet, dass** jedes Paneel (7) ein Querschnittprofil mit Schenkel (9) aufweist, wobei benachbarte zueinander liegende Schenkel (9) einander untergreifen.

5. Elektrische Anlage nach Anspruch 3 oder 4, **dadurch gekennzeichnet, dass** jedes Befestigungselement (5) ein Federelement (12) aufweist.

6. Elektrische Anlage nach Anspruch 5, **dadurch gekennzeichnet, dass** jedes Befestigungselement (5) eine am Kessel (2) befestigte Konsole (10) und eine an der Armierung (4) befestigte Konsole (11) aufweist, wobei die beiden Konsolen (10, 11) mittels des Federelementes (12) verbunden sind.

7. Elektrische Anlage nach Anspruch 5 oder 6, **dadurch gekennzeichnet, dass** das Federelement (12) ein aus einem elastomeren Werkstoff hergestellt ist, der an den Konsolen (10,11) adhäsiv befestigt ist.

8. Elektrische Anlage nach Anspruch 2, **dadurch gekennzeichnet, dass** der Kessel (2) eine Kesseldecke aufweist auf dem Dome (10) und /oder andere Anlagenteile angeordnet sind, wobei die Paneele (7) mit ihrem oberen Ende die Dome (10) und /oder andere Anlagenteile überragen.

9. Elektrische Anlage nach Anspruch 2, **dadurch gekennzeichnet, dass** der Kessel (2) einen Kesseldeckel aufweist, auf dem ein zylinderförmiges Dehngefäß (15) angeordnet ist, dessen Oberfläche mittels Paneele (7) umhüllt ist.

10. Elektrische Anlage nach Anspruch 2, **dadurch gekennzeichnet, dass** die Armierung (4) zumindest ein Paneel (7') aufweist, das in einem Scharnier (14) gelagert und zum Außenraum (21) hin schwenkbar ist.

11. Elektrische Anlage nach Anspruch 2, **dadurch gekennzeichnet, dass** im Zwischenraum (18) zwischen Seitenwand (3) und Armierung (4) ein geräuschdämmendes Material angeordnet ist.

12. Verfahren zum Nachrüsten einer elektrischen Anlage, insbesondere eines Transformators, eines Phasenschiebers oder einer Drossel, mit einem flüssigkeitsgefüllten Kessel (2), der Seitenwände (3) aufweist, wobei an den Seitenwänden (3) eine durchschusshemmende Armierung (4) angebracht wird, die mittels Befestigungselemente (5) am Kessel (3) befestigt wird, und die ringsum die Seitenwände (3) in einem Abstand (6) umhüllt, sodass zumindest der Kessel (3) und gegebenenfalls auf dem Kessel-Deckel angeordnete Anlagenteile vor Beschuss- und Splittereinwirkung geschützt werden, wobei die Armierung aus einem Werkstoff besteht, der eine Zugefestigkeit Rₘ aufweist, die größer als 1000 MPa ist.

13. Verfahren nach Anspruch 12, **dadurch gekennzeichnet, dass** im Zwischenraum (18), gebildet durch die im Abstand (6) zur Seitenwand (3) aufgebrachte Armierung (4) ein geräuschdämmendes Material angeordnet wird.

## Claims

1. Electrical installation, in particular a transformer, phase shifter or inductor, comprising a fluid-filled tank (2) having side walls (3), wherein, for protection against the effect of bullets and/or fragments, a penetration-inhibiting reinforcement (4) is provided, which envelops the side walls (3) on the outside and consists of a material having a tensile strength Rₘ greater than 1000 MPa, **characterised in that** the reinforcement (4) envelops the side walls (3) all-round at a distance (6) and is fastened to the tank (2) by means of a plurality of fastening elements (5).

2. Electrical installation according to claim 1, **characterised in that** the reinforcement (4) is formed of panels (7), wherein adjacent panels (7, 7') overlap each other.

3. Electrical installation according to claim 2, **characterised in that** the panels (7) are arranged vertically and/or horizontally lengthways.

4. Electrical installation according to claim 2 or 3, **characterised in that** each panel (7) has a cross-sectional profile with limbs (9), wherein adjacent limbs (9) interlock.

5. Electrical installation according to claim 3 or 4, **characterised in that** each fastening element (5) has a spring element (12).

6. Electrical installation according to claim 5, **characterised in that** each fastening element (5) has a bracket (10) which is fastened to the tank (2) and a bracket (11) which is fastened to the reinforcement (4), wherein the two brackets (10, 11) are connected by means of the spring element (12).

7. Electrical installation according to claim 5 or 6, **characterised in that** the spring element (12) is made of an elastomeric material which is adhesively fastened to the brackets (10, 11).

8. Electrical installation according to claim 2, **characterised in that** the tank (2) has a tank lid on which domes (10) and/or other installation parts are arranged, wherein the panels (7) at their upper ends extend beyond the domes (10) and/or other installation parts.

9. Electrical installation according to claim 2, **characterised in that** the tank (2) has a tank lid, on which is arranged a cylindrical expansion vessel (15) whose surface is enveloped by means of panels (7).

10. Electrical installation according to claim 2, **characterised in that** the reinforcement (4) comprises at least one panel (7') which is mounted on a hinge (14) and can be swivelled towards the external environment (21).

11. Electrical installation according to claim 2, **characterised in that** a noise-damping material is arranged in the intermediate space (18) between side wall (3) and reinforcement (4).

12. Method for upgrading an electrical installation, in particular a transformer, a phase shifter or an inductor, comprising a liquid-filled tank (2) having side walls (3), wherein a penetration-inhibiting reinforcement (4) is attached to the side walls (3), being fastened to the tank (3) by means of fastening elements (5) and enveloping the side walls (3) all-round at a distance (6), such that at least the tank (3) and if applicable installation parts arranged on the tank lid are protected against the effects of bullets and fragments, wherein the reinforcement consists of a material having a tensile strength Rₘ greater than 1000 MPa.

13. Method according to claim 12, **characterised in that** a noise-damping material is arranged in the intermediate space (18) that is formed by the reinforcement (4) which is attached to the side wall (3) at the distance (6).

## Revendications

1. Installation électrique, en particulier transformateur, déphaseur ou bobine, comprenant une cuve (2) remplie de fluide et pourvue de parois latérales (3), dans laquelle pour assurer la protection contre les effets de tirs et/ou d'éclats, une armure (4) pare-balles est prévue, laquelle enveloppe les parois latérales (3) extérieurement et est formée d'un matériau ayant une résistance à la traction Rₘ supérieure à 1000 MPa, **caractérisée en ce que** l'armure (4) enveloppe les parois latérales (3) tout autour à une distance (6) et est fixée sur la cuve (2) au moyen de plusieurs éléments de fixation (5).

2. Installation électrique selon la revendication 1, **caractérisée en ce que** l'armure (4) est formée de panneaux (7), les panneaux adjacents (7, 7') se chevauchant.

3. Installation électrique selon la revendication 2, **caractérisée en ce que** les panneaux (7) sont disposés verticalement et/ou horizontalement suivant leur extension longitudinale.

4. Installation électrique selon la revendication 2 ou 3, **caractérisée en ce que** chaque panneau (7) a un profil de section transversale avec une branche (9), les branches adjacentes (9) sont en prise l'une sur l'autre par en dessous.

5. Installation électrique selon la revendication 3 ou 4, **caractérisée en ce que** chaque élément de fixation (5) présente un élément à ressort (12).

6. Installation électrique selon la revendication 5, **caractérisée en ce que** chaque élément de fixation (5) présente une console (10) fixée sur la cuve (2) et une console (11) fixée sur l'armure (4), les deux consoles (10, 11) étant reliées au moyen de l'élément à ressort (12).

7. Installation électrique selon la revendication 5 ou 6, **caractérisée en ce que** l'élément à ressort (12) est fait en un matériau élastomère fixé par adhésif sur les consoles (10, 11).

8. Installation électrique selon la revendication 2, **caractérisée en ce que** la cuve (2) présente une couverture de cuve sur laquelle sont agencées des dômes (10) et/ou d'autres éléments de l'installation, les panneaux (7) dépassant les dômes (10) et/ou d'autres éléments de l'installation par leur extrémité supérieure.

9. Installation électrique selon la revendication 2, **caractérisée en ce que** la cuve (2) présente un couvercle de cuve sur lequel est agencé un vase d'expansion (15) de forme cylindrique, dont la surface est enveloppée au moyen de panneaux (7).

10. Installation électrique selon la revendication 2, **caractérisée en ce que** l'armure (4) présente au moins un panneau (7'), lequel est logé dans une charnière (14) et peut pivoter vers l'extérieur (21).

11. Installation électrique selon la revendication 2, **caractérisée en ce qu'**un matériau insonorisant est disposé dans l'espace (18) entre la paroi latérale (3) et l'armure (4) .

12. Procédé pour compléter l'équipement d'une installation électrique, en particulier d'un transformateur, d'un déphaseur ou d'une bobine, comprenant une cuve (2) remplie de fluide et pourvue de parois latérales (3), dans lequel l'on monte sur les parois latérales (3) une armure (4) que l'on fixe sur la cuve (3) au moyen d'éléments de fixation (5) et qui enveloppe les parois latérales (3) tout autour à une distance (6), de telle sorte qu'au moins la cuve (3) et le cas échéant d'autres éléments de l'installation agencés sur le couvercle de la cuve sont protégés contre les effets de tirs et d'éclats, l'armure étant faite en un matériau ayant une résistance à la traction Rₘ supérieure à 1000 MPa.

13. Procédé selon la revendication 12, **caractérisé en ce que** l'on dispose un matériau insonorisant dans l'espace (18) formé par l'armure (4) appliquée à une distance (6) par rapport à la paroi latérale (3).
